# DEMANDE DE BREVET EUROPEEN

(11) **EP 1 796 166 A1**
(43) Date de publication de la demande: **13.06.2007**
(21) Numéro de dépôt: 06291885.9
(22) Date de dépôt: 07.12.2006
(51) Int. Cl.: H01L 23/485

(54) **Puce de circuits intégrés à plots externes et procédé de fabrication d'une telle puce**

(30) Priorité: 09.12.2005 FR 0512500
(71) Demandeur: STMICROELECTRONICS SA, 92120 Montrouge (FR)
(72) Inventeur: Marsanne, Sébastien, 38240 Meylan (FR); Le Briz, Olivier, 38470 Saint-Gervais (FR)
(74) Mandataire: Zapalowicz, Francis

(57) **Abrégé**

Puce de circuits intégrés présentant une couche superficielle diélectrique et, au-dessous de cette couche, des plots internes, et procédé de fabrication d'une telle puce, dans lesquels des multiplicités (7) de vias (9) en un matériau conducteur de l'électricité traversent ladite couche superficielle (4) et sont ménagées respectivement au-dessus desdits plots internes (3), et des plots de contact externe en saillie (10) sont formés sur ladite couche superficielle (4) et reliés respectivement auxdites multiplicités de vias (9).

## Description

La présente invention concerne le domaine des puces de circuits intégrés équipées de plots de contact externe en saillie.

De telles puces sont en particulier destinées à être montées sur des plaques, de telle sorte que leurs plots de contact externe établissent des liaisons électriques sur ces plaques. Pour cela, lors du montage, on presse les puces en direction de plaques munies d'une couche diélectrique présentant en suspension des particules en un matériau conducteur de l'électricité, de telle sorte que les particules situées entre les plaques et les faces d'extrémité ou frontales des plots de contact externe établissent les liaisons électriques.

Actuellement, partant d'une puce comprenant une couche inférieure sur laquelle sont formés des plots internes et une couche superficielle qui recouvre ces derniers et qui présente des bossages de surface dans les zones de ces plots internes, on réalise des ouvertures dans la couche superficielle, au-dessus des plots internes, et on réalise les plots de contact externe et en saillie, par un dépôt par croissance d'un matériau conducteur de l'électricité dans les ouvertures de la couche superficielle et des ouvertures d'un masque provisoire, plus grandes que les ouvertures de la couche superficielle. Il s'ensuit que les faces d'extrémité des plots de contact externe obtenus présentent une partie centrale en creux et un rebord périphérique correspondant au rebord de la couche superficielle entourant l'ouverture correspondante ménagée dans cette couche.

Une telle disposition engendre un affaiblissement de la couche superficielle autour des plots de contact externe et un risque d'apparition de fissures lors du montage précité qui doit être effectué sous des pressions relativement élevées du fait de l'existence desdites parties en creux, ces fissures étant propices à l'apparition d'une corrosion interne de la puce. En outre, comme les plots internes sont en général en aluminium et que les plots de contact externe sont en général en or, il existe un risque de réactions électrochimiques susceptibles, par gonflement de la matière, de détériorer les liaisons électriques et d'accroître encore le risque d'apparition de fissures.

La présente invention a tout d'abord pour objet une puce de circuits intégrés présentant une couche superficielle diélectrique et, au-dessous de cette couche, des plots internes.

Selon l'invention, cette puce comprend des multiplicités de vias en un matériau conducteur de l'électricité traversant ladite couche superficielle et ménagées respectivement au-dessus desdits plots internes, et des plots de contact externe en saillie formés sur ladite couche superficielle et reliés respectivement auxdites multiplicités de vias.

Selon l'invention, lesdites multiplicités de vias sont de préférence ménagés au-dessous de faces frontales plates et lesdits plots de contact externe en saillie sont de préférence formés sur ces faces frontales plates.

Selon l'invention, lesdits plots de contact externe présentent de préférence des faces frontales plates.

Selon une variante préférée de réalisation de l'invention, lesdits plots internes sont en aluminium, lesdits vias sont en tungstène (W) et lesdits plots de contact externe sont en or (Au).

La présente invention a également pour objet un procédé de réalisation de plots de contact externe en saillie sur une puce de circuits intégrés présentant une couche superficielle diélectrique et au-dessous de cette couche des plots internes.

Selon l'invention, ce procédé consiste à réaliser des multiplicités de trous dans ladite couche superficielle respectivement au-dessus des plots internes ; à remplir ces trous d'un matériau conducteur de l'électricité de façon à constituer des vias ; à déposer une couche de masque sur ladite couche superficielle ; à réaliser des ouvertures au travers de ladite couche de masque au-dessus des multiplicités de trous ; à remplir lesdites ouvertures d'un matériau conducteur de l'électricité de façon à constituer des plots de contact externe ; et à enlever ou éliminer ladite couche de masque de telle sorte que ces plots de contact externe sont en saillie au-dessus de ladite couche superficielle et sont reliés auxdits plots internes par lesdits vias.

Selon l'invention, le procédé consiste de préférence à réaliser lesdites ouvertures au-dessus de parties plates de ladite couche superficielle.

Selon l'invention, le remplissage desdites ouvertures est de préférence obtenu en effectuant un dépôt par croissance du matériau dans ces ouvertures jusqu'à sensiblement leur bord.

Selon l'invention, le procédé consiste de préférence à déposer au moins une couche intermédiaire en un matériau conducteur de l'électricité avant le dépôt de ladite couche de masque et à enlever ou éliminer cette couche intermédiaire autour desdits plots de contact externe en saillie après ou lors de l'enlèvement ou l'élimination de ladite couche de masque.

La présente invention sera mieux comprise à l'étude d'une puce de circuits intégrés et de son mode de fabrication, décrits à titre d'exemples non limitatifs et illustrés par le dessin sur lequel :
- La figure 1 représente une coupe partielle d'un puce de circuits intégrés selon l'invention ;
- La figure 2 représente la puce de la figure 1 en cours de fabrication ;
- La figure 3 représente la puce de la figure 1 dans une étape ultérieure de fabrication ;
- Et la figure 4 représente la puce de la figure 1 dans une étape ultérieure de fabrication.

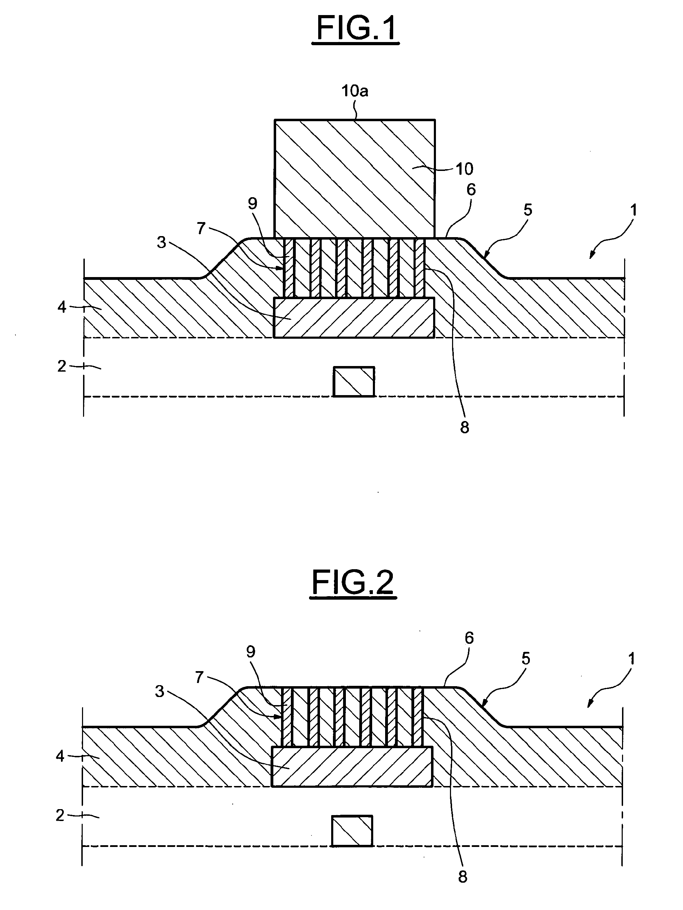

En se reportant à la figure 1, on peut voir qu'on a représenté une puce 1 de circuits intégrés, à plusieurs couches successives, qui comprend une dernière couche 2 sur laquelle sont formés des plots internes métalliques 3 espacés et, sur cette dernière couche 2, une couche superficielle diélectrique 4 dite de passivation, cette couche superficielle 4 présentant des bossages 5 enveloppant par le dessus les plots internes 3 et présentant une face frontale plate 6. Bien entendu, les plots internes 3 sont sélectivement reliés aux circuits intégrés.

Dans la couche superficielle 4 sont ménagées des multiplicités 7 de trous 8 formées respectivement au-dessus des plots internes 3, les trous 8 de chaque multiplicités 7 étant de préférence répartis sous forme de matrices régulières en dessous de la face frontale plate 6.

Dans les trous 8 sont formés des vias 9 en un matériau conducteur de l'électricité.

Sur les faces frontales plates 6 des bossages 5 de la couche superficielle 4 sont formés des plots de contact externe 10 en saillie en un matériau conducteur de l'électricité, par exemple de forme parallélépipédique, de telle sorte que ces plots de contact externe 10 sont respectivement reliés électriquement aux plots internes par l'intermédiaire des vias 9.

Entre le matériau constituant les plots de contact externe 10 et la face frontale 6 du bossage 5, peut être prévue au moins une couche intermédiaire en un matériau conducteur de l'électricité pour par exemple obtenir un bon accrochage des plots de contact externe 10 sur la couche superficielle 4.

Pour fabriquer la structure ci-dessus, on peut utiliser les procédés couramment utilisés dans le domaine de la microélectronique, notamment de gravure, de dépôt, de traitement thermique et de nettoyage, parfaitement connus de l'homme du métier. On peut en particulier procéder de la manière suivante.

Comme le montre la figure 2, partant d'une puce 1 présentant des plots internes 3 en aluminium (Al), on réalise les trous 8. Puis, on remplit ces trous 8 de tungstène (W) pour constituer les vias 9 par des procédés connus.

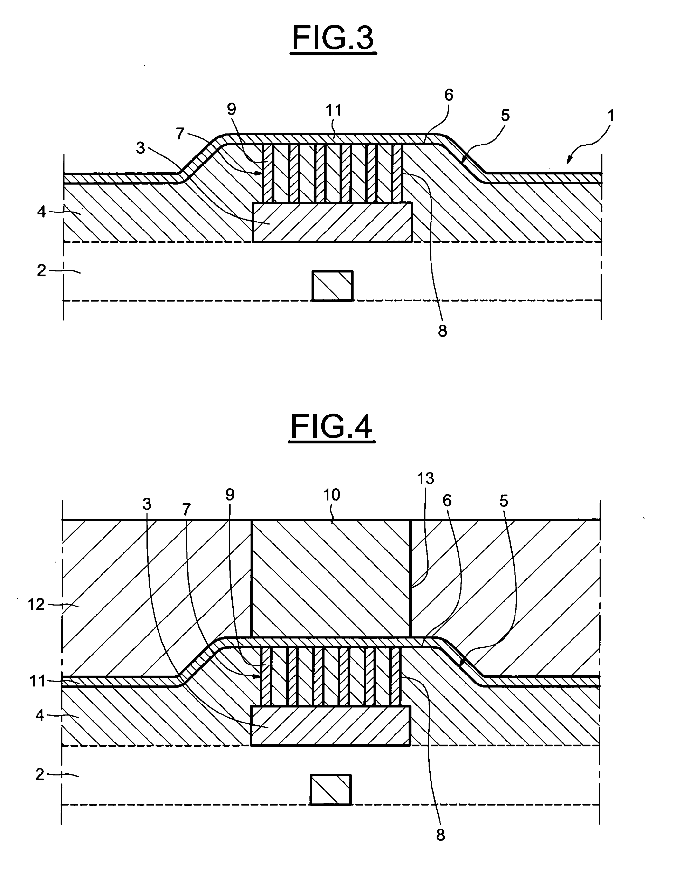

Comme le montre la figure 3, on procède au dépôt d'une couche intermédiaire 11 en or (Au) sur la couche superficielle 4, en interposant éventuellement une couche d'accrochage (UBM).

Comme le montre la figure 4, on forme sur la couche intermédiaire 11 une couche de masque 12 dans laquelle on réalise des ouvertures 13 qui correspondant aux plots 10 à réaliser. Ces ouvertures 12 s'étendent sur une partie de la face frontale 6 des bossages 5 et au-dessus des vias 9.

Puis, on procède au dépôt d'or (Au) par croissance locale dans les ouvertures 13 du dépôt sur la couche intermédiaire 11, de préférence jusqu'à sensiblement le bord de ces ouvertures 13.

Enfin, on procède à l'enlèvement et au nettoyage de toutes les couches formées au-dessus de la surface de la couche superficielle 4 et autour des plots de contact externe 10.

La puce 1 ainsi réalisée présente en particulier les avantages suivants.

Les plots de contact externe 10 étant formés sur une surface plate, ils présentent une face frontale 10a plate. En conséquence, les liaisons électriques par l'intermédiaire de particules s'interposant entre cette face frontale 10a et une plaque peuvent être obtenues sous des pressions diminuées.

Les trous 8 ménagés dans la couche superficielle 4 influencent peu la résistance mécanique de cette couche et la combinaison des plots internes 3, de la couche superficielle 4, des vias 9 et des plots externes 10 constitue une structure résistante. En conséquence, les risques d'apparition de fissures sont réduits. De plus, il n'est pas utile de prévoir des renforts au-dessous des plots internes 3 de telle sorte que l'espace au-dessous de ces plots, utile pour y prévoir des circuits ou composants, peut être indépendant de la position de ces plots.

L'interposition de vias 8 en tungstène entre les plots internes 3 en aluminium et les plots externes 10 en or réduit le risque de réactions électrochimiques et de gonflement qui pourrait provoquer des fissures.

Bien entendu, d'autres métaux que ceux mentionnés ci-dessus pourraient être utilisés.

La présente invention ne se limite pas aux exemples décrits ci-dessus. Des variantes de réalisation sont possibles sans sortir du cadre des revendications annexées.

## Revendications

1. Puce de circuits intégrés présentant une couche superficielle diélectrique et, au-dessous de cette couche, des plots internes, **caractérisé par le fait qu'**elle comprend des multiplicités (7) de vias (9) en un matériau conducteur de l'électricité traversant ladite couche superficielle (4) et ménagées respectivement au-dessus desdits plots internes (3), et des plots de contact externe en saillie (10) formés sur ladite couche superficielle (4) et reliés respectivement auxdites multiplicités de vias (9).

2. Puce selon la revendication 1, **caractérisé par le fait que** lesdites multiplicités de vias sont ménagés au-dessous de faces frontales plates (6) et que lesdits plots de contact externe en saillie (10) sont formés sur ces faces frontales plates (6).

3. Puce selon l'une des revendications 1 et 2, **caractérisé par le fait que** lesdits plots de contact externe présentent des faces frontales (10a) plates.

4. Puce selon l'une quelconque des revendications 1 à 3, **caractérisé par le fait que** lesdits plots internes (3) sont en aluminium (A1), lesdits vias (9) sont en tungstène (W) et lesdits plots de contact externe (10) sont en or (Au).

5. Procédé de réalisation de plots de contact externe en saillie sur une puce de circuits intégrés présentant une couche superficielle diélectrique et au-dessous de cette couche des plots internes, **caractérisé par le fait qu'**il consiste :
à réaliser des multiplicités (7) de trous (8) dans ladite couche superficielle (4) respectivement au-dessus des plots internes (3) ;
à remplir ces trous d'un matériau conducteur de l'électricité de façon à constituer des vias (9) ;
à déposer une couche de masque (12) sur ladite couche superficielle (4) ;
à réaliser des ouvertures (13) au travers de ladite couche de masque (12) au-dessus des multiplicités de trous ;
à remplir lesdites ouvertures (13) d'un matériau conducteur de l'électricité de façon à constituer des plots de contact externe ;
et à enlever ou éliminer ladite couche de masque de telle sorte que ces plots de contact externe sont en saillie au-dessus de ladite couche superficielle et sont reliés auxdits plots internes par lesdits vias.

6. Procédé selon la revendication 5, **caractérisé par le fait qu'**il consiste à réaliser lesdites ouvertures (13) au-dessus de parties plates (6) de ladite couche superficielle (4).

7. Procédé selon l'une des revendications 5 et 6, **caractérisé par le fait que** le remplissage desdites ouvertures est obtenu en effectuant un dépôt par croissance du matériau dans ces ouvertures jusqu'à sensiblement leur bord.

8. Procédé selon l'une quelconque des revendications 5 à 7, **caractérisé par le fait qu'**il consiste à déposer au moins une couche intermédiaire en un matériau conducteur de l'électricité avant le dépôt de ladite couche de masque et à enlever ou éliminer cette couche intermédiaire autour desdits plots de contact externe en saillie après ou lors de l'enlèvement ou l'élimination de ladite couche de masque.
